# EUROPEAN PATENT SPECIFICATION

(11) **EP 3 038 091 B1**
(45) Date of publication and mention of the grant of the patent: **10.03.2021**
(21) Application number: 15200323.2
(22) Date of filing: 16.12.2015
(51) Int. Cl.: G09G 3/3233

(54) **ORGANIC LIGHT EMITTING DIODE DISPLAY AND METHOD FOR SENSING CHARACTERISTIC THEREOF**
ANZEIGE MIT ORGANISCHEN LICHTEMITTIERENDEN DIODEN UND VERFAHREN ZUR ERFASSUNG VON EIGENSCHAFTEN DAVON
DISPOSITIF D'AFFICHAGE À DIODES ÉLECTROLUMINESCENTES ORGANIQUES ET PROCÉDÉ DE DÉTECTION DE LEURS CARACTÉRISTIQUES

(30) Priority: 24.12.2014 KR 20140188873
(43) Date of publication of application: 29.06.2016
(73) Proprietor: LG Display Co., Ltd., Yeongdeungpo-gu Seoul 150-721 (KR)
(72) Inventor: PARK, Dongwon, 410-360 Gyeonggi-do (KR); HONG, Heejung, 158-756 Seoul (KR)
(74) Representative: Morrall, Jonathan Ian McLachlan

(56) References cited:
- WO-A1-2006/063448
- WO-A2-2014/140522

## Description

This application claims the benefit of Korean Patent Application No. 10-2014-0188873 filed on December 24, 2014.

### BACKGROUND OF THE INVENTION

### Field of the Invention

Embodiments of the invention relate to an organic light emitting diode (OLED) display and a method for sensing device characteristics of the OLED display.

### Discussion of the Related Art

Because an organic light emitting diode (OLED) display is a self-emission display device, the OLED display may be manufactured to have lower power consumption and thinner profile than a liquid crystal display requiring a backlight unit. Further, the OLED display has advantages of a wide viewing angle and a fast response time. As a process technology of the OLED display has been developed to a large-screen mass production technology, the OLED display has expanded its market while competing with the liquid crystal display.

Each pixel of the OLED display includes an organic light emitting diode (OLED) having a self-emitting structure. The OLED display displays an input image using a phenomenon, in which the OLED of the pixel emits light when electrons and holes are combined in an organic layer through a current flowing in a fluorescence or phosphorescence organic thin film. An organic compound layer including a hole injection layer HIL, a hole transport layer HTL, an emission layer EML, an electron transport layer ETL, an electron injection layer EIL, etc. is stacked between an anode and a cathode of the OLED.

The OLED display may be variously classified depending on kinds of emission materials, an emission method, an emission structure, a driving method, and the like. The OLED display may be classified into a fluorescent emission type and a phosphorescent emission type depending on the emission method. Further, the OLED display may be classified into a top emission type and a bottom emission type depending on the emission structure. Further, the OLED display may be classified into a passive matrix OLED (PMOLED) display and an active matrix OLED (AMOLED) display depending on the driving method.

Each pixel of the OLED display includes a driving thin film transistor (TFT) controlling a driving current flowing in the OLED depending on data of the input image. Device characteristics of the driving TFT, such as a threshold voltage and a mobility of the driving TFT, may change depending on a process deviation, a driving time, a driving environment, etc. The pixels of the OLED display are degraded due to changes in the device characteristics of the driving TFTs. The degradation of the pixels leads to a reduction in image quality and lifespan of the OLED display. Thus, the OLED display has adopted a technology for sensing changes in the device characteristics of the pixels and properly modifying input data based on the sensing result to compensate for the degradation of the pixels. The changes in the device characteristics of the pixels include changes in the characteristics of the driving TFT including the threshold voltage, the mobility, etc. of the driving TFT.

Because a related art compensation technology periodically senses changes in device characteristics of all of pixels so as to decide changes in device characteristic of each pixel, it takes a long time for the related art compensation technology to sense changes in the device characteristics of the pixels. Further, the related art compensation technology requires a mass memory capable of storing sensing data of all of the pixels.

### SUMMARY OF THE INVENTION

Embodiments of the invention provide an organic light emitting diode display and a method for sensing device characteristics of the organic light emitting diode display capable of reducing a time and a memory capacity required to sense changes in device characteristics of pixels.

In one aspect, there is an organic light emitting diode display comprising a display panel including data lines, scan lines, and pixels, a data driver configured to supply a data signal to the data lines, a gate driver configured to supply a scan signal to the scan lines, a sensing unit configured to sense changes in device characteristics of the pixels, an image analyzer configured to analyze an input image and select a sensing location and a sensing interval, and a timing controller configured to control the data driver and the gate driver.

Pixels of the sensing location among the pixels are directly sensed by the sensing unit, and changes in device characteristics of remaining pixels are calculated based on sensing values from the sensing unit.

The image analyzer changes the sensing location at predetermined time intervals.

The image analyzer divides the input image into a plurality of blocks and analyzes one or more of complexity, gray level distribution, and a motion of an image assigned to each block. The image analyzer selects the sensing interval of each block based on the result of an analysis of the image.

The image analyzer reduces the sensing interval in an image having large complexity and increases the sensing interval in a monotonous image having small complexity.

The image analyzer reduces the sensing interval in an image having a large gray level difference and increases the sensing interval in an image having a small gray level difference.

The image analyzer reduces a time interval changing the sensing location in a motion picture and increases the time interval in a still image.

When the device characteristics of the pixels are sensed, only channels of the data driver, the gate driver, and the sensing unit connected to the pixels of the sensing location are driven under the control of the timing controller.

In another aspect, there is a method for sensing device characteristics of an organic light emitting diode display including a display panel including data lines, scan lines, and pixels, a data driver supplying a data signal to the data lines, a gate driver supplying a scan signal to the scan lines, and a sensing unit sensing changes in device characteristics of the pixels, the method comprising analyzing an input image and selecting a sensing location and a sensing interval, and directly sensing pixels of the sensing location among the pixels and calculating changes in device characteristics of remaining pixels using sensing values obtained from the directly sensed pixels.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:
FIG. 1 is a block diagram of an organic light emitting diode display according to an exemplary embodiment of the invention;
FIG. 2 is an equivalent circuit diagram of a pixel;
FIG. 3 is a waveform diagram showing signals for sensing changes in device characteristic of a pixel;
FIG. 4 shows an example of an image, in which pixels are similarly degraded;
FIG. 5 shows an example of an image, in which degradation degrees of pixels are different from one another;
FIG. 6 is a flow chart showing a method for sensing device characteristics of a display device according to an exemplary embodiment of the invention;
FIG. 7 shows blocks divided from an image of one frame and an example of a sensing interval of each block;
FIG. 8 shows an example of a method for estimating a sensing interval and a degradation degree of an unselected pixel.
FIG. 9 shows an example of an image, in which there is a small change in device characteristic in a vertical direction and there is a large change in device characteristic in a horizontal direction;
FIG. 10 shows an example of an image, in which there is a small change in device characteristic in a horizontal direction and there is a large change in device characteristic in a vertical direction;
FIG. 11 shows an example of an image, in which complexity in a horizontal direction is similar to complexity in a vertical direction; and
FIG. 12 shows an example of an irregular image.

### DETAILED DESCRIPTION OF THE EMBODIMENTS

Reference will now be made in detail to embodiments of the invention, examples of which are illustrated in the accompanying drawings. Wherever possible, the same reference numbers will be used throughout the drawings to refer to the same or like parts. It will be paid attention that detailed description of known arts will be omitted if it is determined that the arts can mislead the embodiments of the invention.

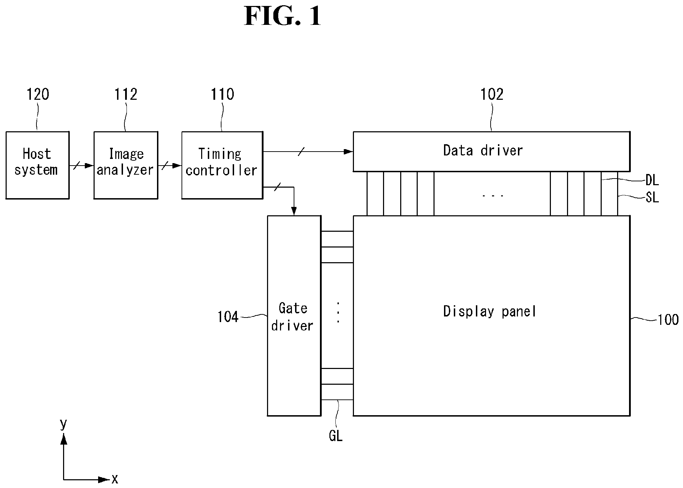

Referring to FIGS. 1 to 3, an organic light emitting diode (OLED) display according to an exemplary embodiment of the invention includes a display panel 100, an image analyzer 112, and a display panel driving circuit.

A pixel array of the display panel 100 displays data of an input image. The pixel array of the display panel 100 includes a plurality of data lines DL, a plurality of scan (or gate) lines GL crossing the data lines DL, and pixels arranged in a matrix form. Each pixel may include a red subpixel, a green subpixel, and a blue subpixel for the color representation. Each pixel may further include a white subpixel. The display panel 100 may include a red color filter, a green color filter, and a blue color filter.

The display panel 100 includes reference lines SL for sensing changes in device characteristics of the pixels. A pair of scan lines may be connected to each subpixel, so that first and second scan signals Scan A and Scan B can be applied to each subpixel.

The change in the device characteristic of the pixel includes changes in characteristics of a driving thin film transistor (TFT), for example, a change amount ΔVth of a threshold voltage of the driving TFT, a change amount Δµ of a mobility of the driving TFT, etc.

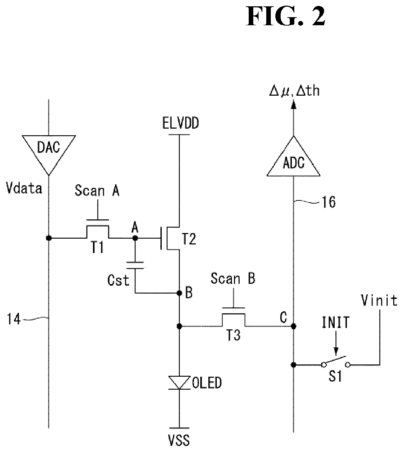

As shown in FIG. 2, each pixel may include three thin film transistors (TFTs) T1, T2, and T3, a storage capacitor Cst, and an organic light emitting diode (OLED), but is not limited thereto.

The OLED may be configured as an organic compound layer including a hole injection layer HIL, a hole transport layer HTL, an emission layer EML, an electron transport layer ETL, an electron injection layer EIL, etc., which are stacked. An anode of the OLED is connected to a source of the second TFT T2, and a cathode of the OLED is connected to a ground level voltage source GND.

The first TFT T1 applies a data signal input through the data line DL to a gate of the second TFT T2 through a first node A in response to the first scan signal Scan A. A gate of the first TFT T1 is connected to a first scan line GL, to which the first scan signal Scan A is applied. A drain of the first TFT T1 is connected to the data line DL, and a source of the first TFT T1 is connected to the gate of the second TFT T2 via the first node A.

The second TFT T2 operates as a driving TFT and adjusts a current flowing in the OLED depending on a gate voltage. A high potential power voltage ELVDD is applied to a drain of the second TFT T2. The source of the second TFT T2 is connected to the anode of the OLED via a second node B.

The third TFT T3 connects the second node B to a third node C in response to the second scan signal Scan B. The third node C is connected to the reference line SL. The third TFT T3 is turned on during a sensing period for sensing changes in the device characteristic of the pixel. The sensing period may be set within a vertical blank period VB, in which data is not written on the pixels. In this instance, the third TFT T3 maintains an off-state during a data enable period, in which data is written on the pixels, and is turned on in response to the second scan signal Scan B during the vertical blank period VB. A drain of the third TFT T3 is connected to the second node B, and a source of the third TFT T3 is connected to the third node C. A gate of the third TFT T3 is connected to a second scan line GL, to which the second scan signal Scan B is applied. The storage capacitor Cst is connected between the gate and the source of the second TFT T2 through the first and second nodes A and B.

The image analyzer 112 analyzes data of the input image received from a host system 120 and analyzes one or more of gray level distribution, complexity, and a motion of the input image in each frame period. An image analysis method may use any known method, for example, a histogram analysis method, an analysis method using an edge filter, a motion vector analysis method, etc. In general, a display device includes an image analysis module embedded in a timing controller 110 and analyzing an input image, so as to improve image quality. In this instance, the embodiment of the invention may use the image analyzer 112 as the existing image analysis module without adding a new component. The image analyzer 112 may be embedded in the timing controller 110.

The image analyzer 112 receives timing signals synchronized with the input image from the host system 120. The timing signals include a vertical sync signal Vsync, a horizontal sync signal Hsync, a data enable signal DE, a dot clock DCLK, and the like. The image analyzer 112 selects a pixel, of which changes in device characteristic are sensed, based on the result of an analysis of the input image and transmits location information of the pixel to the timing controller 110. The image analyzer 112 counts the timing signals and may decide a location of the pixel, of which changes in the device characteristic are sensed.

The image analyzer 112 virtually divides the input image into a plurality of blocks. The image analyzer 112 may analyze the input image on a per block basis and may select an interval (hereinafter, referred to as "a sensing interval") between pixels, which will be directly sensed in each block, and a sensing location based on the result of an analysis of the image. The sensing interval and the sensing location of each block may be changed depending on the result of an analysis of the image. The image analyzer 112 reduces the sensing interval in an image having large complexity and increases the sensing interval in an image having small complexity. The image analyzer 112 reduces the sensing interval in an image having a large gray level difference and increases the sensing interval in an image having a small gray level difference. The image analyzer 112 may change a time interval changing a location of a pixel to be sensed on a time axis based on the result of an analysis of the image. For example, the image analyzer 112 may reduce a time interval changing the sensing location in a motion picture and may increase the time interval in a still image.

The host system 120 may be implemented as one of a television system, a set-top box, a navigation system, a DVD player, a Blu-ray player, a personal computer (PC), a home theater system, and a phone system.

The display panel driving circuit includes a data driver 102, a gate driver 104, and the timing controller 110.

The display panel driving circuit writes the data of the input image on the pixel array of the display panel 100. The display panel driving circuit senses changes in the device characteristics of the pixel and modulates the data of the input image based on the changes in the device characteristics of the pixel, thereby compensating for the changes in the device characteristics of the pixel.

The display panel 100 and/or the data driver 102 include(s) a sensing unit for sensing changes in the device characteristics of the pixels. The sensing unit may include an analog-to-digital converter (ADC) connected to the pixels and at least one switching element.

The data driver 102 includes at least one source driver integrated circuit (IC). The data driver 102 converts data of the input image received from the timing controller 110 into an analog gamma compensation voltage using a digital-to-analog converter (DAC) and generates the data signal. The data driver 102 outputs the data signal to the data lines DL. Each pixel data includes red data, green data, and blue data. Each pixel data may further include white data.

The data driver 102 transmits a sensing value received through the ADC to the timing controller 110. The ADC, the DAC, and a switch S1 shown in FIG. 2 may be embedded in the data driver 102. The sensing value is digital data obtained from the pixels, of which changes in the device characteristics are directly sensed by the sensing unit.

The gate driver 104 supplies a scan signal (or a gate pulse) synchronized with an output voltage of the data driver 102 to the scan lines GL during the data enable period under the control of the timing controller 110. The gate driver 104 supplies the scan signal for sensing changes in the device characteristics to the scan lines GL during the vertical blank period. Thus, the gate driver 104 sequentially shifts the scan signal and sequentially selects the pixels, to which data is applied, on a per line basis. Further, the gate driver 104 sequentially selects sequentially selects the pixels, of which changes in the device characteristics will be sensed, on a per line basis.

The data driver 102 and the gate driver 104 drive all of channels during a period, in which image data is applied to the pixels, under the control of the timing controller 110. The timing controller 110 may selectively turn on or off driving channels of the data driver 102, the gate driver 104, and the sensing unit, so as to drive only the channels connected to the pixel of the sensing location. Hence, power consumption may be minimized during the sensing period.

The timing controller 110 receives the pixel data of the input image and the timing signals from the host system 120. The timing controller 110 generates timing control signals for controlling operation timings of the data driver 102 and the gate driver 104 based on the timing signals Vsync, Hsync, DE, and DCLK received along with the pixel data of the input image.

The timing controller 110 may execute an image quality compensation algorithm calculating a compensation value based on the sensing value received through the ADC. The image quality compensation algorithm may use any known algorithm compensating for changes in the device characteristics of the OLED display. The image quality compensation algorithm obtains the sensing values from the pixels of the sensing location, calculates changes in device characteristics of remaining pixels using the sensing values, and estimates changes in the device characteristics of the remaining pixels. The image quality compensation algorithm stores the sensing value received through the ADC in a memory (not shown), selects a compensation value previously set based on the sensing value, and modulates the data of the input image using the compensation value. The compensation value may be added to or subtracted from the data of the input image to produce an offset value compensating for the threshold voltage of the driving TFT. Further, the compensation value may be multiplied by the pixel data to produce a gain value compensating for the mobility of the driving TFT. The timing controller 110 transmits the pixel data modulated by the image quality compensation algorithm to the data driver 102. As described above, the embodiment of the invention compensates for the changes in the device characteristics of the pixels and thus can increase the lifespan of the OLED display.

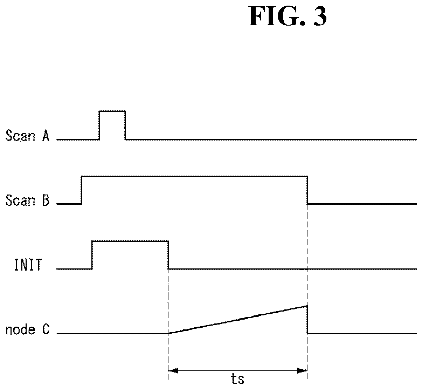

FIG. 2 is an equivalent circuit diagram of a pixel and is an equivalent circuit diagram showing one subpixel. FIG. 3 is a waveform diagram showing signals for sensing changes in device characteristic of a pixel. FIGS. 2 and 3 merely show an example of configuration of the pixel and an example of a method for sensing the device characteristic of the pixel. Therefore, the embodiment of the invention is not limited thereto.

Referring to FIGS. 2 and 3, the timing controller 110 generates the first and second scan signals Scan A and Scan B and an initialization pulse INIT during the vertical blank period. A pulse width of the first scan signal Scan A is less than a pulse width of the second scan signal Scan B. A width of the initialization pulse INIT is greater than the pulse width of the first scan signal Scan A and is less than pulse width of the second scan signal Scan B. After the second scan signal Scan B rises, the initialization pulse INIT and the first scan signal Scan A sequentially rise. Subsequently, after the first scan signal Scan A falls, the initialization pulse INIT and the second scan signal Scan B sequentially fall.

The data driver 102 supplies a previously set data signal to the data lines DL during the vertical blank period, so as to sense changes in the device characteristics of the pixels. In the embodiment disclosed herein, the previously set data signal is a signal set to a predetermined voltage irrespective of the data signal of the input image

The third TFT T3 is turned on in response to the second scan signal Scan B and connects the second node B to the third node C. Subsequently, the initialization pulse INIT turns on the switch S1 and supplies a predetermined initialization voltage Vinit to the third node C. The initialization voltage Vinit initializes the second node B and the third node C. Subsequently, the first scan signal Scan A is generated, and the predetermined data signal is applied to the gate of the second TFT T2. Hence, voltages of the second and third nodes B and C rise. The ADC converts changes in the voltage of the third node C rising for a sensing time ts into digital and outputs a sensing value. The sensing value is information indicating changes in the device characteristic of the pixel and is transmitted to the timing controller 110.

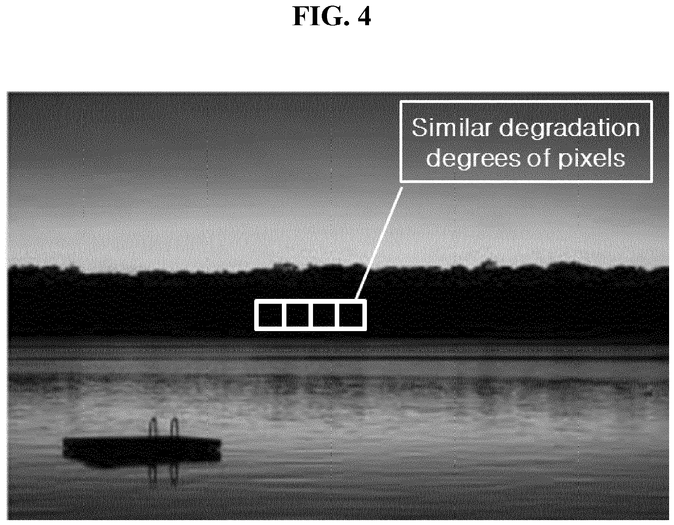

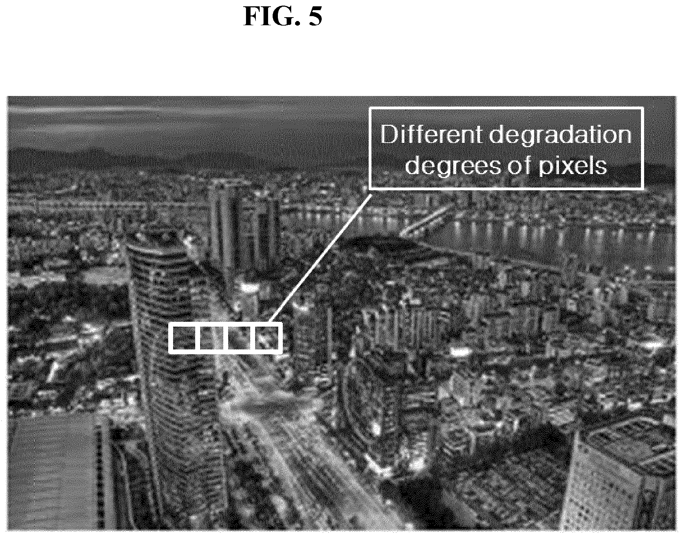

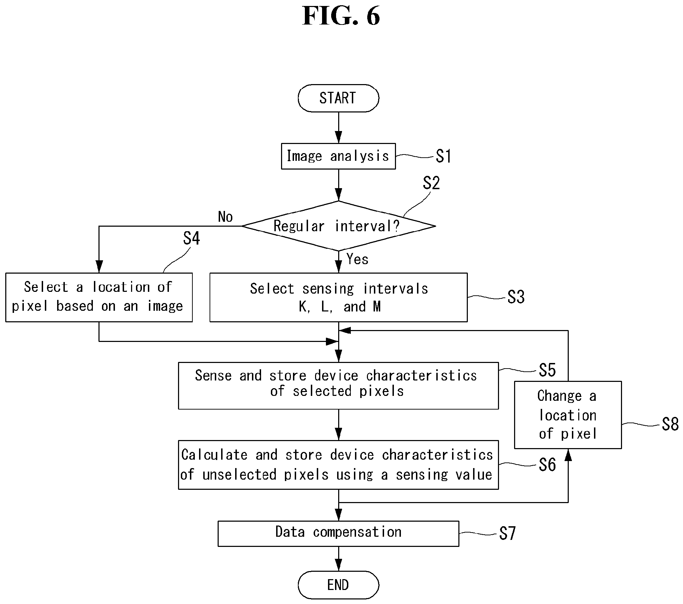

Degradation degrees of the pixels may be different from one another depending on the input image. For example, in an image shown in FIG. 4, pixels, to which pixel data of the same gray level or similar gray levels are applied, are similarly degraded. On the contrary, in an image shown in FIG. 5, degradation degrees of pixels, to which pixel data of different gray levels are applied, are different from one another. Because high gray level data stresses the driving TFT T2 of the pixel more than low gray level data, the pixel receiving the high gray level data may be degraded more rapidly than the pixel receiving the low gray level data. As shown in FIG. 6, the embodiment of the invention changes an interval between the pixels to be sensed and changes a sensing time based on the degradation degree of the pixel depending on the input image.

FIG. 6 is a flow chart showing a method for sensing the device characteristics of the display device according to the embodiment of the invention.

Referring to FIG. 6, the device characteristic sensing method analyzes an input image in step S1 and decides a sensing interval based on the result of an analysis of the input image in step S2.

The device characteristic sensing method virtually divides the input image into a plurality of blocks. When complexities and/or gray levels of one block in a horizontal direction (for example, x-axis direction) and a vertical direction (for example, y-axis direction) are the same or similar, the device characteristic sensing method selects the sensing interval of the one block as a regular interval in step S3. The sensing interval is an interval between pixels, of which changes in the device characteristic will be directly sensed. The sensing interval includes a spatial distance between pixels in one frame period and a time interval changing the sensing location on a time axis in one frame period. The spatial distance includes a sensing distance K of the horizontal direction (x-axis direction) and a sensing distance L of the vertical direction (y-axis direction).

If there is pixel data, in which complexity and/or gray level difference of one block are greater than a previously set threshold value, the device characteristic sensing method may select the sensing interval of the one block as an irregular interval in accordance with characteristic of the input image in step S4. The sensing intervals K, L, and M each increase in a portion, in which the complexity and/or the gray level difference of one block are the same or similar. On the other hand, the sensing intervals K, L, and M each decrease in a portion, in which the complexity and/or the gray level difference of one block are greater than the predetermined threshold value. The threshold value may include two or more threshold values so as to variously select the sensing interval depending on the input image.

Subsequently, the embodiment of the invention selects pixels separated from each other at the sensing interval selected in the step S3 or S4, directly senses changes in device characteristics of the selected pixels, and stores a sensing value in the memory in step S5. The embodiment of the invention calculates changes in device characteristics of unselected pixels using the sensing value, estimates a degradation degree of the unselected pixels, and stores it in the memory in step S6.

The embodiment of the invention changes a location of the pixel, senses device characteristic of the pixel, and calculates device characteristics of remaining pixels using the sensing value. Hence, the embodiment of the invention applies a direct sensing method and an indirect sensing method to all of the pixels in step S7. The indirect sensing method calculates changes in device characteristics of other pixels using the sensing values and estimates degradation degrees of the other pixels which are not directly sensed.

The embodiment of the invention changes a location of a pixel to be sensed in each frame period, or at predetermined time intervals, or at time intervals changed based on an image analysis, so that all of the pixels of one block can be directly sensed. The embodiment of the invention may change a location of a pixel to be sensed through a method for rotating a location of a pixel to be directly sensed in previously set order and may directly sense all of the pixels of one block. Because the embodiment of the invention calculates changes in device characteristics of other pixels using the sensing value and estimates the degradation degree of the other pixels, a direct sensing cycle of the pixel is much longer than a related art.

Subsequently, the embodiment of the invention estimates a degradation degree of each pixel based on the collected sensing values of the device characteristics of the pixels and the collected calculation values of the device characteristics of the pixels and reflects a compensation value on data, thereby compensating for the degradation of each pixel in step S8.

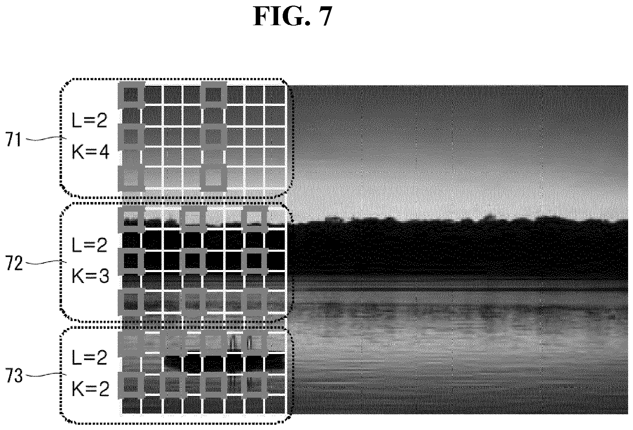

FIG. 7 shows blocks divided from an image of one frame and an example of a sensing interval of each block.

Referring to FG. 7, the image analyzer 112 divides an image of one frame into a plurality of blocks 71 to 73.

In the image of one frame shown in FIG. 7, a first block 71 includes pixel data representing a sky, a second block 72 includes pixel data representing water and a wood, and a third block 73 includes pixel data representing a boat floating on the water.

Because the pixel data of the first block 71 represents the monotonous sky represented at similar gray levels, the pixel data of the first block 71 is almost similar. When pixel data of an image shown in FIG. 7 is written on pixels of the first block 71, degradation degrees of the pixels of the first block 71 are similar. The embodiment of the invention increases the sensing interval in the first block 71. In particular, because there is a small change in the pixel data of the first block 71 in the horizontal direction and there is a relatively small change in the pixel data of the first block 71 in the vertical direction, the sensing distance K increases, and the sensing distance L relatively decreases.

Because an image of the second block 72 is a boundary portion between the sky and the wood, there is a small change in pixel data of the second block 72 in the horizontal direction and a change in pixel data of the second block 72 in the vertical direction is larger than the first block 71. Thus, the sensing distance K of the second block 72 increases, and the sensing distance L of the second block 72 relatively decreases.

In an image of the third block 73, pixel data having a large gray level difference are written in both the horizontal direction and the vertical direction. Thus, the sensing distances K and L of the third block 73 decrease.

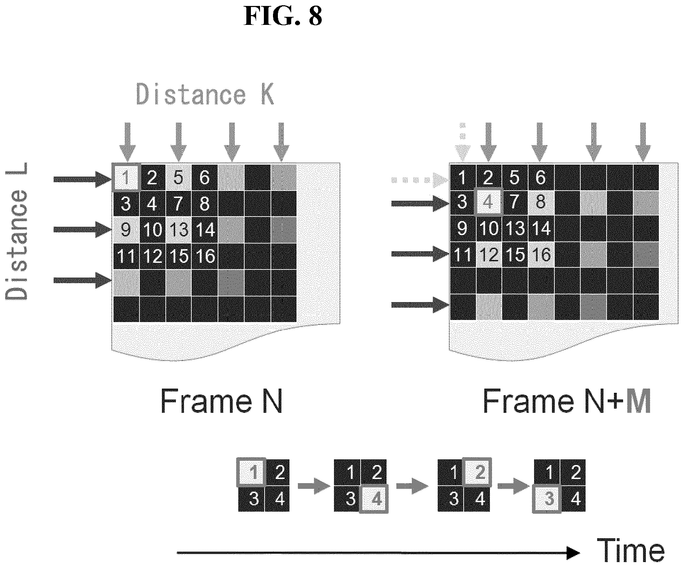

FIG. 8 shows an example of a method for estimating a sensing interval and a degradation degree of an unselected pixel.

Referring to FIG. 8, the embodiment of the invention decides the sensing intervals K, L, and M based on the result of an image analysis.

The embodiment of the invention may set the sensing intervals K and L to "1" in an Nth frame period and may directly sense device characteristics of first, fifth, ninth, and thirteenth pixels, where N is a positive integer. The embodiment of the invention calculates device characteristics of unselected pixels using a sensing value in the Nth frame period. Device characteristics of the unselected pixels (for example, second, third, and fourth pixels) in the Nth frame period may be calculated through a known interpolation method using the sensing values of the selected first, fifth, ninth, and thirteenth pixels. For example, the device characteristics of the fourth pixel may be calculated through the interpolation method using two or more of the sensing values of the first, fifth, ninth, and thirteenth pixels.

The embodiment of the invention changes a location of the pixel in an N+M frame period and senses the device characteristics of the fourth pixel, where M is a positive integer. The location of the pixel may change at predetermined time intervals or depending on the result of an analysis of the input image.

Because changes in device characteristics of pixels in a motion picture are irregular and rapid, it is preferable, but not required, that a sensing cycle of the device characteristic of the pixel decreases. On the other hand, because device characteristics of pixels in a still image excessively change and degradation degrees of the pixels linearly change, a sensing cycle of the device characteristic of the pixel increases. Hence, it is easy to estimate the degradation degrees of the pixels in the still image. Thus, the embodiment of the invention reduces the sensing interval M in an input image (for example, motion picture) having a large change in the device characteristic on the time axis and increases the sensing interval M in an input image (for example, still image) having a small change in the device characteristic on the time axis.

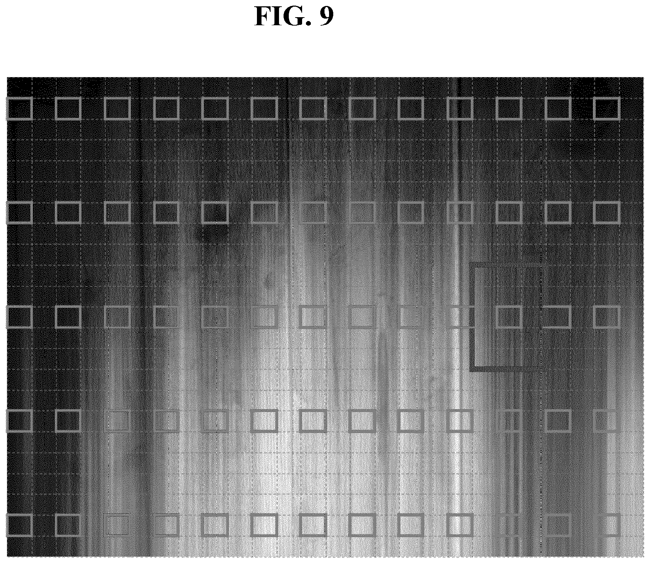

FIG. 9 shows an example of an image, in which there is a small change in device characteristic in the vertical direction and there is a large change in device characteristic in the horizontal direction.

In an image shown in FIG. 9, there is a small change in gray level in the vertical direction, and there is a relatively large change in gray level in the horizontal direction. In other words, degradation degrees of adjacent pixels in the vertical direction are similar to one another, and degradation degrees of adjacent pixels in the horizontal direction are different from one another. Because of this, even through the sensing distance L of the vertical direction increases, a sensing error is scarcely generated between the pixels arranged along the vertical direction. On the other hand, when the sensing distance K of the horizontal direction increases, a sensing error between the pixels arranged along the horizontal direction may increase because there is a large change in the device characteristics of the adjacent pixels in the horizontal direction. Thus, when the image shown in FIG. 9 is input, the embodiment of the invention selects the sensing distance L of the vertical direction as a value greater than the sensing distance K of the horizontal direction. For example, in FIG. 9, the sensing distances L and K are 5 and 2, respectively.

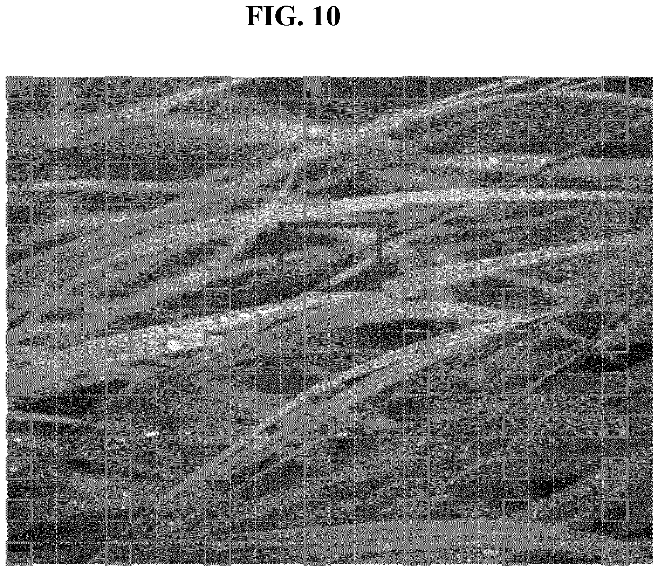

FIG. 10 shows an example of an image, in which there is a small change in device characteristic in the horizontal direction and there is a large change in device characteristic in the vertical direction.

In an image shown in FIG. 10, there is a small change in gray level in the horizontal direction, and there is a relatively large change in gray level in the vertical direction. In other words, degradation degrees of adjacent pixels in the horizontal direction are similar to one another, and degradation degrees of adjacent pixels in the vertical direction are different from one another. Because of this, even through the sensing distance K of the horizontal direction increases, a sensing error is scarcely generated between the pixels arranged along the horizontal direction. On the other hand, when the sensing distance L of the vertical direction increases, a sensing error between the pixels arranged along the vertical direction may increase because there is a large change in the device characteristics of the adjacent pixels in the vertical direction. Thus, when the image shown in FIG. 10 is input, the embodiment of the invention selects the sensing distance K of the horizontal direction as a value greater than the sensing distance L of the vertical direction. For example, in FIG. 10, the sensing distances L and K are 2 and 4, respectively.

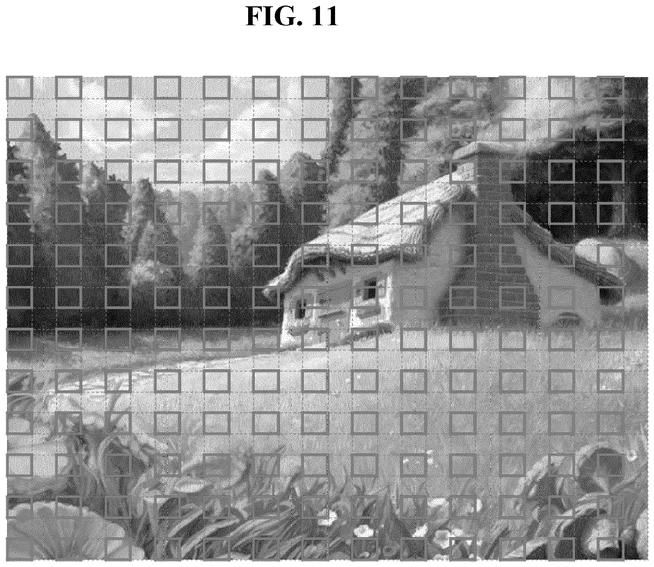

FIG. 11 shows an example of an image, in which complexity in the horizontal direction is similar to complexity in the vertical direction.

In an image shown in FIG. 11, changes in gray level in the horizontal direction are similar to changes in gray level in the vertical direction. In the image shown in FIG. 11, the sensing distance K of the horizontal direction and the sensing distance L of the vertical direction are equally selected. For example, in FIG. 11, the sensing distances L and K are 2 and 2, respectively.

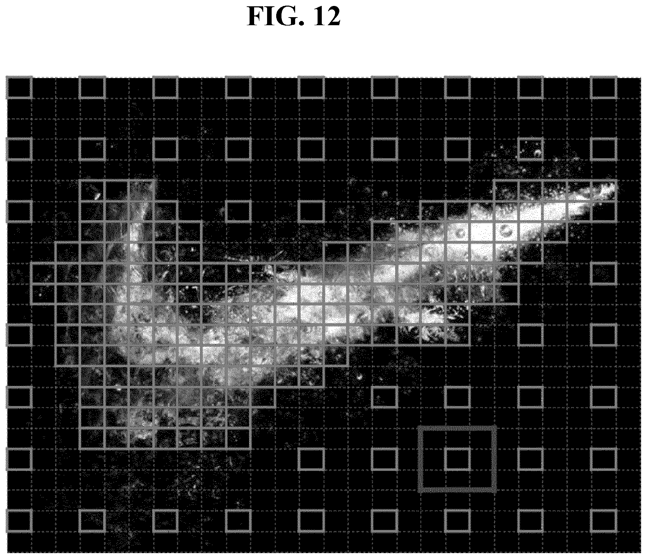

FIG. 12 shows an example of an irregular image.

In an image shown in FIG. 12, there is a large difference between a gray level of a middle portion and a gray level of a background. Further, there is a large difference between complexity of the middle portion of the image and complexity of the background. In the image having the large complexity, there is a large difference between degradation degrees of adjacent pixels. On the contrary, in a monotonous image having small complexity, degradation degrees of adjacent pixels are similar. In the image shown in FIG. 12, the sensing interval in the middle portion is narrowly selected, and the sensing interval in the background is widely selected.

The embodiment of the invention drives only the pixels of the sensing location and can greatly reduce the power consumption of the data driver 102 and the gate driver 104. The timing controller 110 may control the data driver 102 and the gate driver 104, so that only the pixels of the sensing location can be driven based on information on the sensing location received from the image analyzer 112. For example, the timing controller 110 may control the data driver 102, so that only source output channels connected to the pixels of the sensing location through the data line among source output channels of the data driver 102 are driven, and remaining source output channels are not driven. The non-driven source output channels may be floated. Because the ADC, the buffer, etc. are not driven in the non-driven source output channels, the power consumption is scarcely generated. The timing controller 110 may control the gate driver 104, so that only gate output channels connected to the pixels of the sensing location through the gate line among gate output channels of the gate driver 104 are driven, and remaining gate output channels are not driven. The non-driven gate output channels may be floated. The power consumption is scarcely generated in the non-driven gate output channels.

The embodiment of the invention selects the pixels to be sensed based on the result of an analysis of the input image and directly senses device characteristics of the selected pixels. The embodiment of the invention calculates changes in device characteristics of other pixels using two or more sensing values and estimates degradation degrees of the other pixels. Thus, the embodiment of the invention directly sense some pixels of the input image and calculates changes in device characteristics of remaining pixels using the sensing values. Therefore, time, the memory, etc. required to sense the pixels may be improved.

When the gray levels of pixel data written on the pixels are similar, the pixels are similarly degraded. On the other hands, the pixels, on which pixel data having the large complexity and/or the large gray level difference is written, are differently degraded. The embodiment of the invention optimizes the sensing interval between the pixels to be sensed depending on the input image based on such a phenomenon, thereby reducing the number of pixels to be directly sensed and reducing the sensing error between the directly sensed pixels and the indirectly sensed pixels.

As described above, the embodiment of the invention senses changes in the device characteristics of some pixels of the input image and calculates changes in device characteristics of other pixels using the sensing values. The embodiment of the invention changes the sensing interval based on the result of an analysis of the input image. Thus, the embodiment of the invention can reduce time, the memory capacity, etc. required to sense changes in the device characteristics of the pixels of the OLED display.

Furthermore, the embodiment of the invention drives only the channels of the driving circuit connected to the pixels to be sensed during a period, in which changes in the device characteristics of the pixels are sensed, thereby reducing the power consumption of the OLED display.

## Claims

1. An organic light emitting diode display comprising:
a display panel (100) including data lines (DL), scan lines (SL), and pixels displaying data of an input image;
a data driver (102) operable to supply a data signal to the data lines;
a gate driver (104) operable to supply a scan signal to the scan lines;
a sensing unit operable to sense a sensing value of pixels, wherein the sensing value indicates a change in a device characteristic of the pixel;
an image analyzer (112) operable to analyze the input image, to select a plurality of pixels and to select a sensing interval between pixels to be directly sensed by the sensing unit, based on the result of the analyzed input image, and to transmit location information of the plurality of pixels to a timing controller (110); and
wherein the timing controller (110) is operable to transmit pixel data modulated by an image quality compensation algorithm based on the sensing value to the data driver and control the data driver and the gate driver,
wherein the pixels of the selected plurality of pixels are directly sensed by the sensing unit, and changes in the device characteristics of remaining pixels are calculated based on the sensing values from the sensing unit.

2. The organic light emitting diode display of claim 1, wherein the device characteristic is a degradation degree.

3. The organic light emitting diode display of claim 1 or 2, wherein the image analyzer is operable to select the plurality of pixels by selecting a sensing location of a pixel.

4. The organic light emitting diode display of claim 3, wherein the selected plurality of pixels are pixels in one frame and the sensing interval includes a spatial distance between the pixels in the one frame.

5. The organic light emitting diode display of claim 3 or 4, wherein the image analyzer is further operable to select a time interval for changing the sensing location and wherein the image analyzer changes the sensing location at each time interval.

6. The organic light emitting diode display of claim 3, wherein the image analyzer divides the input image into a plurality of blocks and analyzes one or more of gray level distribution and a motion of an image assigned to each block, and
wherein the image analyzer selects the sensing interval of each block based on the result of an analysis of the image.

7. The organic light emitting diode display of claim 3, wherein the image analyzer reduces the sensing interval in an image having a large gray level difference and increases the sensing interval in an image having a small gray level difference.

8. The organic light emitting diode display of claim 7, wherein the image analyzer reduces the time interval for changing the sensing location in a motion picture and increases the time interval in a still image.

9. The organic light emitting diode display of any preceding claim, wherein when the sensing values of the selected plurality of pixels are sensed, only channels of the data driver, the gate driver, and the sensing unit connected to the pixels of the selected plurality of pixels are driven under the control of the timing controller.

10. A method for determining device characteristics of pixels of the organic light emitting diode display of any preceding claim, the method comprising:
analyzing an input image, selecting a sensing interval between pixels to be directly sensed by the sensing unit and selecting a plurality of pixels based on the result of the analyzed input image; and
directly sensing pixels of the selected plurality of pixels and calculating changes in the device characteristics of remaining pixels using the sensing values obtained from the selected plurality of pixels.

11. The method of claim 10, wherein the steps of selecting a plurality of pixels comprises selecting a sensing location of a pixel.

12. The method of claim 11, further comprising changing the sensing location at predetermined time intervals.

13. The method of claim 11, wherein the selecting of the sensing location and the sensing interval include:
dividing the input image into a plurality of blocks and analyzing one or more of gray level distribution, and a motion of an image assigned to each block; and
selecting the sensing interval of each block based on the result of an analysis of the image.

14. The method of claim 13, further comprising:
reducing the sensing interval in an image having a large gray level difference and increasing the sensing interval in an image having a small gray level difference,
and optionally,
the method further comprising reducing a time interval changing the sensing location in a motion picture and increasing the time interval in a still image.

15. The method of claim any one of claims 10 to 14, further comprising, when the sensing values of the selected plurality of pixels are sensed, driving only channels connected to the pixels of the selected plurality of pixels among channels of the data driver, the gate driver, and the sensing unit.

## Patentansprüche

1. Anzeige mit organischen Leuchtdioden, die Folgendes umfasst:
eine Anzeigetafel (100), die Datenleitungen (DL), Abtastleitungen (SL) und Pixel enthält, die Daten eines Eingabebildes anzeigen;
einen Datentreiber (102), der betrieben werden kann, um ein Datensignal zu den Datenleitungen zu liefern;
einen Gate-Treiber (104), der betrieben werden kann, um ein Abtastsignal zu den Abtastleitungen zu liefern;
eine Erfassungseinheit, die betrieben werden kann, um einen Erfassungswert von Pixeln zu erfassen, wobei der Erfassungswert eine Änderung in einer Vorrichtungscharakteristik des Pixels anzeigt;
einen Bildanalysator (112), der betrieben werden kann, um das Eingabebild zu analysieren, um mehrere Pixel auszuwählen und um basierend auf dem Ergebnis des analysierten Eingabebilds ein Erfassungsintervall zwischen Pixeln, die durch die Erfassungseinheit direkt erfasst werden müssen, auszuwählen, und um Ortsinformationen der mehreren Pixel zu einer Zeitsteuereinrichtung (110) zu übertragen; und
wobei die Zeitsteuereinrichtung (110) betrieben werden kann, um Pixeldaten, die basierend auf dem Erfassungswert durch einen Bildqualitätskompensationsalgorithmus moduliert worden sind, zu dem Datentreiber zu übertragen, und den Datentreiber und den Gate-Treiber zu steuern,
wobei die Pixel der mehreren ausgewählten Pixel durch die Erfassungseinheit direkt erfasst werden und Änderungen in den Vorrichtungscharakteristika der verbleibenden Pixel basierend auf den Erfassungswerten von der Erfassungseinheit berechnet werden.

2. Anzeige mit organischen Leuchtdioden nach Anspruch 1, wobei die Vorrichtungscharakteristik ein Abbaugrad ist.

3. Anzeige mit organischen Leuchtdioden nach Anspruch 1 oder 2, wobei der Bildanalysator betrieben werden kann, um die mehreren Pixel durch Auswählen eines Erfassungsortes eines Pixels auszuwählen.

4. Anzeige mit organischen Leuchtdioden nach Anspruch 3, wobei die mehreren ausgewählten Pixel Pixel in einem Rahmen sind und das Erfassungsintervall eine räumliche Entfernung zwischen den Pixeln in dem einen Rahmen enthält.

5. Anzeige mit organischen Leuchtdioden nach Anspruch 3 oder 4, wobei der Bildanalysator ferner betrieben werden kann, um ein Zeitintervall zum Ändern des Erfassungsortes auszuwählen, und wobei der Bildanalysator den Erfassungsort in jedem Zeitintervall ändert.

6. Anzeige mit organischen Leuchtdioden nach Anspruch 3, wobei der Bildanalysator das Eingabebild in mehrere Blöcke unterteilt und eine Graustufenverteilung und/oder eine Bewegung eines Bildes, die jedem Block zugewiesen werden, analysiert, und
wobei der Bildanalysator das Erfassungsintervall jedes Blocks basierend auf dem Ergebnis eines Analyse des Bilds auswählt.

7. Anzeige mit organischen Leuchtdioden nach Anspruch 3, wobei der Bildanalysator das Erfassungsintervall in einem Bild, das eine große Graustufendifferenz aufweist, verringert, und das Erfassungsintervall in einem Bild, das eine kleine Graustufendifferenz aufweist, erhöht.

8. Anzeige mit organischen Leuchtdioden nach Anspruch 7, wobei der Bildanalysator das Zeitintervall zum Ändern des Erfassungsortes in einem Bewegtbild verringert und das Zeitintervall in einem Standbild erhöht.

9. Anzeige mit organischen Leuchtdioden nach einem der vorhergehenden Ansprüche, wobei dann, wenn die Erfassungswerte der mehreren ausgewählten Pixel erfasst werden, nur Kanäle des Datentreibers, des Gate-Treibers und der Erfassungseinheit, die mit den Pixeln der mehreren ausgewählten Pixel verbunden sind, unter der Steuerung der Zeitsteuereinrichtung angesteuert werden.

10. Verfahren zum Bestimmen von Vorrichtungscharakteristika von Pixeln der Anzeige mit organischen Leuchtdioden nach einem der vorhergehenden Ansprüche, wobei das Verfahren Folgendes umfasst:
Analysieren des Eingangsbilds, Auswählen eines Erfassungsintervalls zwischen Pixeln, die direkt durch die Erfassungseinheit erfasst werden müssen, und Auswählen mehrerer Pixel basierend auf dem Ergebnis des analysierten Eingangsbilds; und
direktes Erfassen von Pixeln der mehreren ausgewählten Pixel und Berechnen von Änderungen in den Vorrichtungscharakteristika der verbleibenden Pixel unter Verwendung der Erfassungswerte, die aus den mehreren ausgewählten Pixeln erhalten worden sind.

11. Verfahren nach Anspruch 10, wobei die Schritte des Auswählens mehrerer Pixel das Auswählen eines Erfassungsortes eines Pixels umfasst.

12. Verfahren nach Anspruch 11, das ferner das Ändern des Erfassungsortes in vorbestimmten Zeitintervallen umfasst.

13. Verfahren nach Anspruch 11, wobei das Auswählen des Erfassungsortes und des Erfassungsintervalls Folgendes enthält:
Unterteilen des Eingangsbilds in mehrere Blöcke und Analysieren einer Graustufenverteilung und/oder einer Bewegung eines Bildes, die jedem Block zugewiesen sind; und
Auswählen des Erfassungsintervalls jedes Blocks basierend auf dem Ergebnis einer Analyse des Bildes.

14. Verfahren nach Anspruch 13, das ferner Folgendes umfasst:
Verringern des Erfassungsintervalls in einem Bild, das eine große Graustufendifferenz aufweist, und Erhöhen des Erfassungsintervalls in einem Bild, das eine kleine Graustufendifferenz aufweist,
und wahlweise,
das Verfahren ferner das Verringern eines Zeitintervalls zum Ändern des Erfassungsort in einem Bewegtbild und das Erhöhen des Zeitintervalls in einem Standbild umfasst.

15. Verfahren nach einem der Ansprüche 10 bis 14, das ferner, dann, wenn die Erfassungswerte der mehreren ausgewählten Pixel erfasst worden sind, das Antreiben ausschließlich der Kanäle, die mit den Pixeln der mehreren ausgewählten Pixeln verbunden sind, unter den Kanälen des Datentreibers, des Gate-Treibers und der Erfassungseinheit umfasst.

## Revendications

1. Affichage à diodes électroluminescentes organiques comprenant :
un panneau d'affichage (100) comprenant des lignes de données (DL), des lignes de balayage (SL) et des pixels affichant les données d'une image d'entrée ;
un circuit d'attaque de données (102) pouvant être utilisé pour fournir un signal de données aux lignes de données ;
un circuit d'attaque de porte (104) pouvant être utilisé pour fournir un signal de balayage aux lignes de balayage ;
une unité de détection pouvant fonctionner pour détecter une valeur de détection de pixels, où la valeur de détection indique un changement dans une caractéristique de dispositif du pixel ;
un analyseur d'image (112) pouvant fonctionner pour analyser l'image d'entrée, pour sélectionner une pluralité de pixels et pour sélectionner un intervalle de détection entre des pixels à détecter directement par l'unité de détection, sur la base du résultat de l'image d'entrée analysée, et pour transmettre des informations de localisation de la pluralité de pixels à un contrôleur de synchronisation (110) ; et
où le contrôleur de synchronisation (110) peut être utilisé pour transmettre des données de pixels modulées par un algorithme de compensation de la qualité de l'image basé sur la valeur de détection au circuit d'attaque de données et pour contrôler le circuit d'attaque de données et le circuit d'attaque de porte,
où les pixels de la pluralité de pixels sélectionnés sont directement détectés par l'unité de détection, et les changements des caractéristiques de dispositif des pixels restants sont calculés sur la base des valeurs de détection de l'unité de détection.

2. Affichage à diodes électroluminescentes organiques selon la revendication 1, dans lequel la caractéristique du dispositif est un degré de dégradation.

3. Affichage à diodes électroluminescentes organiques selon la revendication 1 ou la revendication 2, dans lequel l'analyseur d'image peut être utilisé pour sélectionner la pluralité de pixels en sélectionnant un emplacement de détection d'un pixel.

4. Affichage à diodes électroluminescentes organiques selon la revendication 3, dans lequel la pluralité de pixels sélectionnés sont des pixels dans une trame et l'intervalle de détection comprend une distance spatiale entre les pixels dans la trame.

5. Affichage à diodes électroluminescentes organiques selon la revendication 3 ou la revendication 4, dans lequel l'analyseur d'image peut en outre être utilisé pour sélectionner un intervalle de temps pour changer l'emplacement de détection, et dans lequel l'analyseur d'image change l'emplacement de détection à chaque intervalle de temps.

6. Affichage à diodes électroluminescentes organiques selon la revendication 3, dans lequel l'analyseur d'image divise l'image d'entrée en une pluralité de blocs et analyse un ou plusieurs éléments parmi la distribution des niveaux de gris et le mouvement d'une image assignée à chaque bloc, et
où l'analyseur d'image sélectionne l'intervalle de détection de chaque bloc en fonction du résultat d'une analyse de l'image.

7. Affichage à diodes électroluminescentes organiques selon la revendication 3, dans lequel l'analyseur d'image réduit l'intervalle de détection dans une image ayant une grande différence de niveaux de gris et augmente l'intervalle de détection dans une image ayant une petite différence de niveaux de gris.

8. Affichage à diodes électroluminescentes organiques selon la revendication 7, dans lequel l'analyseur d'image réduit l'intervalle de temps pour changer l'emplacement de détection dans un film et augmente l'intervalle de temps dans une image fixe.

9. Affichage à diodes électroluminescentes organiques selon l'une quelconque des revendications précédentes, dans lequel, lorsque les valeurs de détection de la pluralité sélectionnée de pixels sont détectées, seuls les canaux du circuit d'attaque de données, du circuit d'attaque de porte, et de l'unité de détection connectée aux pixels de la pluralité de pixels sélectionnés sont commandés sous le contrôle du contrôleur de synchronisation.

10. Procédé pour déterminer les caractéristiques de dispositif des pixels de l'affichage à diodes électroluminescentes organiques selon l'une quelconque des revendications précédentes, le procédé comprenant :
l'analyse d'une image d'entrée, la sélection d'un intervalle de détection entre les pixels à détecter directement par l'unité de détection et la sélection d'une pluralité de pixels sur la base du résultat de l'image d'entrée analysée ; et
la détection directe des pixels de la pluralité de pixels sélectionnés, et le calcul des modifications des caractéristiques de dispositif des pixels restants à l'aide des valeurs de détection obtenues à partir de la pluralité de pixels sélectionnés.

11. Procédé selon la revendication 10, dans lequel les étapes de sélection d'une pluralité de pixels comprennent la sélection d'un emplacement de détection d'un pixel.

12. Procédé selon la revendication 11, comprenant en outre la modification de l'emplacement de détection à des intervalles de temps prédéterminés.

13. Procédé selon la revendication 11, dans lequel la sélection de l'emplacement de détection et de l'intervalle de détection comprend :
la division de l'image d'entrée en une pluralité de blocs et l'analyse d'un ou plusieurs éléments parmi la distribution des niveaux de gris et le mouvement d'une image assignée à chaque bloc ; et
la sélection de l'intervalle de détection de chaque bloc en fonction du résultat d'une l'analyse de l'image.

14. Procédé selon la revendication 13, comprenant en outre :
la réduction de l'intervalle de détection dans une image ayant une grande différence de niveaux de gris et l'augmentation de l'intervalle de détection dans une image ayant une petite différence de niveaux de gris,
et, de manière optionnelle,
le procédé comprend en outre la réduction de l'intervalle de temps modifiant l'emplacement de détection dans un film et l'augmentation de l'intervalle de temps dans une image fixe.

15. Procédé selon l'une quelconque des revendications 10 à 14, comprenant en outre, lorsque les valeurs de détection de la pluralité de pixels sélectionnés sont détectées, la commande uniquement des canaux connectés aux pixels de la pluralité de pixels sélectionnés parmi les canaux du circuit d'attaque de données, du circuit d'attaque de porte et de l'unité de détection.
